# EUROPÄISCHE PATENTANMELDUNG

(11) **EP 2 246 982 A2**
(43) Veröffentlichungstag der Anmeldung: **03.11.2010**
(21) Anmeldenummer: 10159844.9
(22) Anmeldetag: 14.04.2010
(51) Int. Cl.: H03K 17/06

(54) **Schaltung zum Schalten kapazitiver Lasten**

(30) Priorität: 27.04.2009 DE 102009018996
(71) Anmelder: Siemens Aktiengesellschaft, 80333 München (DE)
(72) Erfinder: Berz, Arno, 76287 Rheinstetten (DE)

(57) **Zusammenfassung**

Erfindungsgemäß wird eine Schaltung zum niederohmigen Schalten einer Kapazität (C), mit einem Spannungspotential (P5V) einer Gleichspannungsquelle vorgeschlagen, das über einen elektronischen Schalter (V1) mit der zu schaltenden Kapazität (C) elektrisch verbindbar ist, wobei ein ohmscher Widerstand (R) parallel zur Kapazität (C) liegt. Ein Transistor (V4) ist zur Ansteuerung des elektronischen Schalters (V1) mit dessen Steueranschluss (G) verbunden. Durch Rückkopplung einer zwischen der Kapazität (C) und dem Transistor (V4) liegenden Kondensator (C1) ist das Spannungspotential am Steueranschluss (G) des elektronischen Schalters (V1) derart veränderbar, dass ein intermittierendes Aufladen der Kapazität (C) über den elektronischen Schalter (V1) erfolgt, und dass im Ladeendzustand der Kapazität (C) der elektronische Schalter (V1) dauernd leitend ist.

## Beschreibung

Die Erfindung betrifft eine Schaltung zum Schalten einer Kapazität, mit einem Spannungspotential einer Gleichspannungsquelle, die über einen elektronischen Schalter mit der zu schaltenden Kapazität verbunden ist, wobei ein ohmscher Widerstand parallel zur Kapazität liegt.

Derartige Schaltungen finden in der Elektronik zahlreiche Anwendung. Z.B. werden in modernen Personalcomputern und Industriepersonalcomputern zur Einsparung elektrischer Energie verschiedene Spannungen je nach Bedarf ein- und ausgeschaltet. Vor allem, wenn die vorhandenen Stützkondensatoren niederohmig geschaltet werden, können kurzschlussartige, hohe Ströme auftreten. Durch große Kapazitäten an der ungeschalteten Spannung und kleine Kapazitäten an der geschalteten Spannung werden hohe Ströme vermieden. Ebenso werden durch Induktivitäten die hohen Stromtransienten begrenzt.

Der Erfindung liegt die Aufgabe zugrunde, eine Schaltung der oben genannten Art vorzuschlagen, bei der das Spannungspotential der Gleichspannungsquelle möglichst niederohmig auf die Kapazität schaltbar ist.

Die Aufgabe wird mit den Merkmalen nach Anspruch 1 gelöst.

Weiterbildungen der Erfindung sind den Unteransprüchen zu entnehmen.

Ein Ausführungsbeispiel der Erfindung wird im Folgenden anhand einer Zeichnung näher erläutert. Es zeigen:
- FIG 1: eine Prinzipschaltung zum Schalten einer Kapazität nach dem Stand der Technik und
- FIG 2: eine erfindungsgemäße Schaltung zum Schalten einer Kapazität.

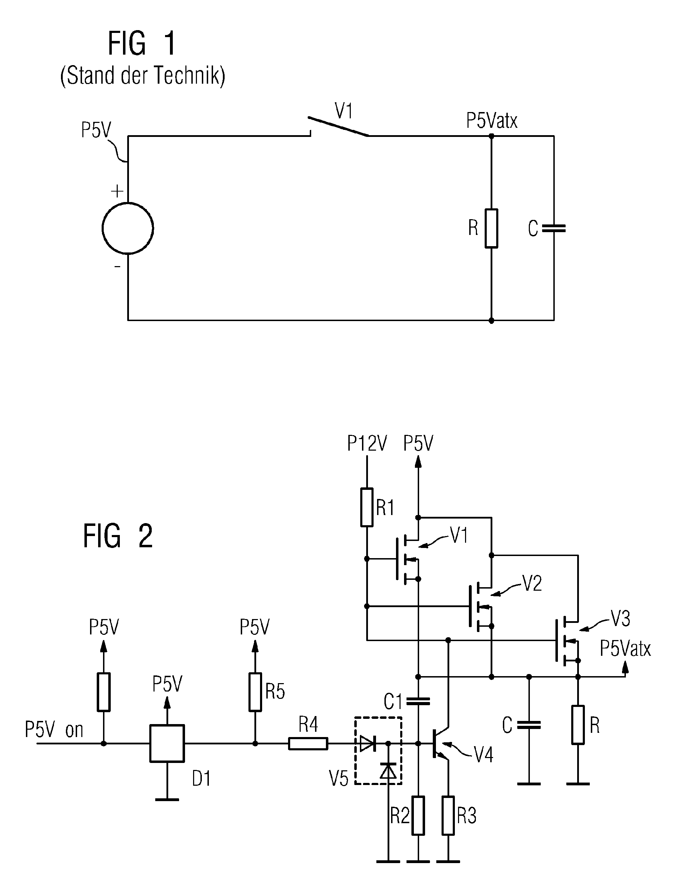

Die in FIG 1 dargestellte Schaltung zum Schalten einer kapazitiven Last bzw. einer Kapazität C gemäß dem Stand der Technik weist eine Gleichspannungsquelle mit einem Spannungspotential P5V auf, das über einen Schalter V1, üblicherweise einen elektronischen Schalter, mit der Kapazität C elektrisch verbindbar ist. Parallel zur Kapazität C liegt eine ohmsche Last R, über die die Kapazität C vor dem Schaltvorgang entladen wird. An der Kapazität C liegt das während des Ladevorgangs veränderliche Spannungspotential P5Vatx an.

Mit der Schaltung nach FIG 2 wird erfindungsgemäß das Spannungspotential P5V über den elektronischen Schalter V1 niederohmig auf das Spannungspotential P5Vatx geschaltet. Bei dem Ausführungsbeispiel nach FIG 2 ist der elektronische Schalter durch drei parallel zueinander liegende Feldeffekttransistoren V1, V2, V3 gebildet, die einerseits an das Spannungspotential P5V und andererseits an die Kapazität C und den dazu parallelen ohmschen Widerstand R mit dem veränderlichen Spannungspotential P5Vatx angeschlossen sind. Der Steueranschluss G des elektronischen Schalters, hier der Gateanschluss der Feldeffekttransistoren V1,V2,V3, liegt über einen ohmschen Widerstand R1 an der Hilfsspannung P12V sowie am Kollektor eines Transistors V4, dessen Basis B über einen Kondensator C1 mit der Kapazität C verbunden ist. Über diesen Kondensator C1 wird eine Spannungsänderung an dem Spannungspotential P5Vatx an die Basis B von Transistor V4 so entgegengekoppelt, dass das Spannungspotential am Steueranschluss G der Feldeffekttransistoren V1,V2,V3 wieder sinkt und so dem Schaltvorgang entgegenwirkt. Der Strom wird auf diese Weise aus dem Spannungspotential P5V wie im Folgenden näher beschrieben begrenzt.

Über einen Inverter D1 und eine dazu in Reihe liegende, mit der Basis B verbundene Doppeldiode V5 wird mithilfe des Signals P5Von die Basis B von Transistor V4 auf Low-Pegel gezogen. Die Basis-Emitterspannung des Transistors V4 sinkt unter die kritische Schwelle von 0.6V und der Transistor V4 fängt an zu sperren. Am Kollektor des Transistors V4 steigt das Potential allmählich über den ohmschen Widerstand R1 an, der an der Hilfsspannung P12V hängt. Aufgrund der ansteigenden Gate-Source-Spannung werden die Feldeffekttransistoren V1,V2,V3 leitend und das Spannungspotential P5Vatx steigt an. Die Änderung des Spannungspotentials P5Vatx bewirkt einen Strom im Kondensator C1, der das Spannungspotential an der Basis B des Transistors V4 hebt. Da die Doppeldiode V5 nun in Sperrrichtung betrieben wird, wird der Transistor V4 wieder leitend und sperrt die Feldeffekttransistoren V1,V2,V3. Daraufhin wird die Änderung des Spannungspotentials P5Vatx unterbunden und der Strom im Kondensator C1 reduziert sich. Das Spannungspotential an der Basis B des Transistors V4 sinkt über den Widerstand R2 und bewirkt das Sperren des Transistors V4. Dieser Vorgang wiederholt sich bis das Spannungspotential P5Vatx das Spannungspotential P5V erreicht hat und nicht mehr ansteigen kann. In diesem Falle steigt die Gate-Spannung an den Feldeffekttransistoren V1,V2,V3 auf die Hilfsspannung P12V und die Feldeffekttransistoren V1,V2,V3 werden niederohmig leitend.

Die erfindungsgemäße Schaltung ist derart aufgebaut, dass eine Spannungsänderung an der zu ladenden Kapazität C, die am Schaltungsausgang liegt, negativ dem Schaltvorgang entgegenwirkt. Die Spannungsänderung an der Kapazität C bewirkt einen Lade- oder Entladestrom durch den Kondensator C1. Bei steigender Spannung an der Kapazität C ergibt sich ein Ladestrom, der ein steigendes Potential an der Basis B des Transistors V4 zur Folge hat, das dem Einschaltvorgang entgegenwirkt. Der Entladestrom bei fallender Spannung an der Kapazität C senkt das Potential an der Basis des Transistors V4 und bewirkt schließlich den Einschaltvorgang. Die Größe der Rückkopplung wird durch den Eingangswiderstand des Transistors V4 und des Basiswiderstands R2 sowie die Größe des rückkoppelnden Kondensators C1 bestimmt.

Der mit dem Emitter des Transistors V4 verbundene ohmsche Widerstand R3 erhöht den Eingangswiderstand des Transistors V4 entsprechend dem Produkt aus dem ohmschen Widerstandswert von R3 und der Stromverstärkung des Transistors V4. Damit sind kleinere Kapazitätswerte für den Kondensator C1 für den gewünschten rampenartigen Aufladevorgang möglich. Die Einschaltrampe für das Spannungspotential P5Vatx ist linear und wird von der Kapazität C, von dem Eingangswiderstand an der Basis B, von dem ohmschen Widerstand R2 und von der Kapazität des Kondensator C1 bestimmt. Die Doppeldiode V5 sorgt zum einen für die Isolation der Basis B und führt zum anderen zum Entladen des Kondensators C1, wenn über den Low-Pegel des Signals P5Von und dann High-Pegel nach dem Inverter D1 die Doppeldiode V5 wieder geöffnet wird, da der Transistor V4 über den Inverter D1, die ohmschen Widerstände R4 und R5 und die nun leitende Doppeldiode V5 angesteuert und leitend wird.

Der Kondensator C1 als Rückkopplungsmittel ist nur ein Ausführungsbeispiel. Alternativ ist auch der Einsatz eines Optokopplers, einer Induktivität oder eines sonstigen Signalwandlers möglich.

## Patentansprüche

1. Schaltung zum Schalten einer Kapazität (C), mit einem Spannungspotential (P5V) einer Gleichspannungsquelle, das über einen elektronischen Schalter (V1) mit der zu schaltenden Kapazität (C) elektrisch verbindbar ist, wobei ein ohmscher Widerstand (R) parallel zur Kapazität (C) liegt, **dadurch gekennzeichnet, dass** ein Transistor (V4) zur Ansteuerung des elektronischen Schalters (V1) mit dessen Steueranschluss (G) verbunden ist, und dass durch ein Rückkopplungsmittel (C1), das zwischen der Kapazität (C) und dem Transistor (V4) liegt, das Spannungspotential am Steueranschluss (G) des elektronischen Schalters (V1) derart veränderbar ist, dass ein intermittierendes Aufladen der Kapazität (C) über den elektronischen Schalter (V1) erfolgt, und dass im Ladeendzustand der Kapazität (C) der elektronische Schalter (V1) dauernd leitend ist.

2. Schaltung nach Anspruch 1, **dadurch gekennzeichnet, dass** das Rückkopplungsmittel (C1) als Kondensator ausgeführt ist.

3. Schaltung nach Anspruch 1 oder 2, **dadurch gekennzeichnet, dass** der elektronische Schalter (V1) als Feldeffekttransistor ausgeführt ist.

4. Schaltung nach einem der Ansprüche 1 bis 3, **dadurch gekennzeichnet, dass** der elektronische Schalter durch eine Parallelschaltung aus mehreren Feldeffekttransistoren (V1,V2, V3) ausgeführt ist.

5. Schaltung nach einem der vorangehenden Ansprüche, **dadurch gekennzeichnet, dass** der Kondensator (C1) mit der Basis (B) des Transistors (V4) verbunden ist und der Kollektor (K) des Transistors (V4) mit dem Steueranschluss (G) des elektronischen Schalters (V1) verbunden ist.
